# EUROPÄISCHE PATENTSCHRIFT

(11) **EP 1 273 851 B1**
(45) Veröffentlichungstag und Bekanntmachung des Hinweises auf die Patenterteilung: **19.09.2018**
(21) Anmeldenummer: 02009715.0
(22) Anmeldetag: 30.04.2002
(51) Int. Cl.: H03K 17/94, F24C 7/08

(54) **Gargerät mit Stelleinheit**
Cooking appliance with control device
Appareil de cuisson avec dispositif de commande

(30) Priorität: 07.07.2001 DE 10133135
(43) Veröffentlichungstag der Anmeldung: 08.01.2003
(60) Teilanmeldung: 10010498.3
(73) Patentinhaber: Electrolux Professional AG, 6210 Sursee (CH)
(72) Erfinder: Schütz, Friedrich, 4800 Zofingen (CH)
(74) Vertreter: Electrolux Group Patents

(56) Entgegenhaltungen:
- EP-A- 1 158 838
- DE-A1- 19 645 678
- DE-A1- 19 903 300
- US-A- 4 121 204
- US-A- 4 204 204
- US-A- 4 386 347
- US-A- 5 559 301

## Beschreibung

Die Erfindung betrifft ein Gargerät mit wenigstens einer Stelleinheit. Stelleinheiten von Haushaltsgargeräten sind üblicherweise als Drehsteller realisiert, mit denen beispielsweise die Heizleistung von Kochstellen stufenlos oder auch in Stufen einstellbar ist. Darüber hinaus sind Bedieneinheiten mit Tastaturen bekannt, die Drucktasten, Folientasten oder Berührungstasten aufweisen, um gewünschte Werte durch wiederholtes Betätigen einzustellen. So zeigen DE 198 17 195 C1 und der DE 298 11 628 U1 Kochfeld-Bedienbereiche, deren tastaturartig aufgebaute touch-control-Sensoren auf Siebensegment- oder Bargraphanzeigen wirken. Eingeformte Berührungstasten für Haushaltsgeräte offenbart die DE 295 19 714 U1 .

Während sich im Bereich der Drehsteller leicht Speisereste festsetzen oder von dort entlang der Drehachse in das Geräteinnere gelangen können, sind wiederholt zu betätigende Tastatursteller wenig bedienfreundlich.

Aus der US-A-4 121 204 ist ein Ein- und Ausgabegerät - mit einer säulengrafikartigen Anzeige aus mehreren nebeneinander angeordneten Anzeigelementen und darüberliegenden berührungsempfindlichen Bereichen bekannt, wobei bei Berührung eines nes berührungsempfindlichen Bereiches ein korrespondierendes und alle weiteren Anzeigeelemente einer Seite aktiviert werden. Die US-A-4 204 204 zeigt eine Ein- und Ausschalteanordnung für eine soeben beschriebene Einrichtung mit säulengrafikartiger Anzeige und darüberliegenden berührungsempfindlichen Bereichen. In der US-A-4 386 347 ist ein säulengrafikartiges Ein- und Ausgabesystem mit einer größeren Anzahl von Anzeigeelementen als Schaltelementen und automatischer Niveauregelung nach Berührung beschrieben. Aus der US-A-5 559 301 schließlich ist ein Touchscreen-Interface für ein Klangerzeugungssystem bekannt, das ein Knopfsymbol aufweist, bei dessen Berührung ein durch Berührung drehbarer Knopf dargestellt wird.

Der Erfindung liegt daher die Aufgabe zugrunde, ein Gargerät zu schaffen, dessen Stelleinheit geringe Verschmutzungsneigung mit hohem Bedienkomfort verbindet.

Erfindungsgemäß wird diese Aufgabe durch die Merkmale des Anspruchs 1 gelöst.

Die Stelleinheit des Gargerätes weist einen berührungsempfindlichen Stellstreifen auf, dessen Stellabschnitten Stellwerte oder Stellwertbereiche einer vorbestimmten Stellkurve zugeordnet oder wahlweise zuordenbar sind. Dem Stellstreifen sid ein oder mehrere zusätzliche Modi zugeordnet oder wahlweise zuordenbar, die durch vorbestimmte Berührungsdauer wählbar sind.

Der Stellstreifen ist vorzugsweise geradlinig ausgebildet, könnte aber auch bogen- oder kreisförmig verlaufen. Den Stellabschnitten sind jeweils ein oder mehrere berührungsempfindliche Sensoren zugeordnet, die insbesondere kapazitiv, induktiv, optisch, thermisch, piezoelektrisch oder dgl. arbeiten und berührbare Plattenbereiche besitzen oder mit diesen zusammenwirken.

Dem Stellstreifen ist vorzugsweise ein Anzeigestreifen zugeordnet, dessen Anzeigeabschnitte korrespondierenden Stellabschnitten des Stellstreifens zugeordnet oder wahlweise zuordenbar sind. Die Anzeigeabschnitte weisen neben jeweils einer oder mehreren Lichtemitterdioden und/oder einem oder mehreren Grafikdisplays (bzw. Bereichen von diesen) Plattenbereiche auf, die untereinander und mit den Plattenbereichen der Stellabschnittte verbunden sein können. Vorzugsweise besitzt jeder Anzeigeabschnitt oder jede vorbestimmte Gruppe von Anzeigeabschnitten eine andere Farbe.

Die Aktivierung der Anzeigeabschnitte folgt der Berührung der Stellabschnitte, wobei die Berührung eines Stellabschnittes zur Aktivierung eines zugeordneten Anzeigeabschnitts oder eines von einem vorbestimmten Ende des Anzeigestreifens ausgehenden Bandes von Anzeigeabschnitten führen kann. Darüber hinaus kann die Aktivierung des oder der Anzeigeabschnitte des Anzeigestreifens bis zur nächsten Berührung des Stellstreifens erhalten bleiben.

Die Stellkurve verläuft von einem Minimalwert zu einem Maximalwert, wobei der Minimalwert insbesondere einem Auszustand des Haushaltsgerätes entspricht.

Die Modi sind auf dem Anzeigestreifen anzeigbar und können insbesondere ein oder mehrere durch Berührung aktivierbare Softkeys oder Zoom-Funktionen bereitstellen..

Der oder den Zoom-Funktionen sind vorzugsweise wenigstens ein Anzeigeabschnitt des Anzeigestreifens und/oder eine zusätzliche Zoom-Anzeige zugeordnet. Die Zoom-Einstellung geschieht durch abschnittsweises und/oder ein oder mehrmaliges Überstreichen des Stellstreifens.

Als Stellwerte kommen insbesondere Leistung, Temperatur, Druck, Feuchtigkeit, Umluft oder dgl. in Frage.

Die Plattenbereiche der Stell- und/oder Anzeigeabschnitte bilden ein Bedien- und/oder Anzeigefeld, das vorzugsweise Teil einer Umhüllung des Haushaltsgerätes ist. Zumindest dieser Teil der Umhüllung ist dielektrisch. Er kann aber auch (beispielsweise bei piezoelektrischer Ausbildung der Sensoren) metallisch sein. Gemäß einer bevorzugten Ausbildung ist zumindest der das Bedien- und/oder Anzeigefeld bildende Teil der Umhüllung plattenförmig, beispielsweise als Teil einer Frontplatte eines Kochgerätes oder einer Platte eines Kochfeldes, insbesondere einer Glaskeramikplatte oder einer Edelstahlplatte.

Ein Gargerät weist wenigstens eine Stelleinheit auf, deren Stellstreifen ein oder mehrere, an unterschiedlichen Stellen angeordnete Anzeigestreifen zugeordnet sind. Als Gargeräte werden hierbei auch Koch-, Brat-, Back-, Dampf- und Räuchergeräte und dgl. angesehen, die im häuslichen und/oder im gewerblichen (professionellen) Bereich zum Einsatz kommen können.

Die Stelleinheit ist kompromißlos hygienisch, läßt intuitive Bedienung zu und bietet unmittelbare optische Rückmeldung an.

Die Erfindung wird nachstehend anhand eines Ausführungsbeispiels näher erläutert. In den zugehörigen schematischen Zeichnungen zeigen:
- Fig. 1: eine Stell- und Anzeigeeinheit in Draufsicht,
- Fig. 2: die Stell- und Anzeigeeineit im Soft-Key-Mode,
- Fig. 3: die Stell- und Anzeigeeinheit im Zoom-Mode und

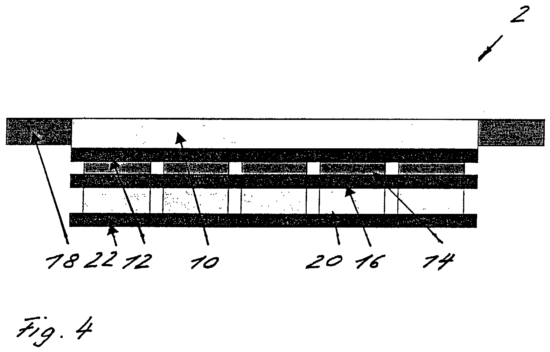

- Fig. 4: die Stell- und Anzeigeeinheit in Seitenansicht..

Die Stell- und Anzeigeeinheit 2 eines nichtdargestellten Kochgerätes weist als Mensch-Maschine-Schnittstelle einen Stellstreifen 4 und einen Anzeigestreifen 6 auf, die ein Bedienfeld 8 bilden.

Der Stellstreifen 4 besteht von oben nach unten gesehen aus einer Abdeckung 10, einer Beschriftungsmaske 12 und einem metallische Sensorflächen 14 tragenden dielektrischen Träger 16. Die Abdeckung 10, beispielsweise eine Glasplatte, ist in einer Frontplatte 18 des Kochgerätes aufgenommen bzw. integriert. Die Beschriftungsmaske 12 ist als Keil ausgebildet, der den Anstieg von einem Minimalwert zu einem Maximalwert symbolisiert. Die vorzugsweise 16 Sensorflächen 14 sind in einer Linie angeordnet und bilden einen Sensorstreifen.

Der Anzeigestreifen 6 wiederum besteht von außen nach innen gesehen aus der Abdeckung 10 und einem Lichtemitterdioden 20 tragenden Träger 22, der auch den Träger 16 trägt. Während der Träger 22 vorzugsweise als Leiterplatte ausgebildet ist, besteht der Träger 16 aus einer Leiterfolie. Die vorzugsweise 16 Lichtemitterdioden bilden einen zum Sensorstreifen parallel verlaufenden Leuchtbalken, wobei jeder Sensorfläche 14 genau ein Stellwert und genau eine Lichtemitterdiode 20 zugeordnet ist, was andere festinstallierte oder (über eine nichtdargestellte Steuerung) wählbare Zuordnungen nicht ausschließt.

Die einzelnen Stellwerte bilden eine nichtdargestellte vorbestimmte Stellkurve, beispielsweise eine lineare oder logarithmische stellwegabhängige Leistungs- oder Temperaturkurve, die festinstalliert oder über die nichtdargestellte Steuerung automatisch oder wahlweise vorgebbar ist.

Im engeren Sinne kann auch die Einheit von Sensorstreifen und Leuchtbalken als Bedienfeld bezeichnet werden, das auf einer flexiblen dielektrischen Folie, einer starren dielektrischen Platte oder einer Kombination aus beidem basiert bzw. aufgebaut ist. Obwohl in verschiedenen Ebenen dargestellt, ließen sich beide Träger auch auf ein und derselben Ebene anordnen bzw. zu einem Träger verschmelzen. Um den Betriebszustand aus unterschiedlichen Blickwinkeln sichtbar zu machen, sind mit einem Sensorstreifen auch mehrere, an unterschiedlichen Gerätepositionen angeordnete Leuchtbalken ansteuerbar. Unterschiedliche Farbbereiche innerhalb des Leuchtbalkens dienen der besseren Assoziation des Stellwertes (z. B. rot für hohe Temperaturen). Die Abdeckung 10 kann aus Glas, Kunststoff, Stein oder anderem dielektrischen Material sein, bei piezo-technischen Sensoren auch aus elektrisch leitendem Material, vorzugsweise Chromnickelstahl. Sie sollte zwischen 0,1 und 10 mm dick sein, vorzugsweise 4 mm. Die vorzugsweise zwischen (transparenter) Abdeckung 10 und Bedienfeld (im engeren Sinne) eingefügten Beschriftungsmaske 12 trägt neben dem optischen Erscheinungsbild alle notwendigen Beschriftungen des Bedienfeldes.

Die Wirkungsweise ist folgende:
Berührt ein Finger F den Stellstreifen 4, bilden sich zwischen dem auf einem Bezugspotential liegenden Finger F und den gegenüberliegenden Sensorflächen 14 Kapazitäten aus, die einen auswertbaren Signalstrom bewirken, der (über die nichtdargestellte Steuereinheit) zur Ansteuerung der jeweils zugeordneten Lichtemitterdioden 20 und zur Aktivierung eines zugeordneten Stellwertes führt. Die Ansteuerung der Lichtemitterdioden ist auf verschiedene Weise möglich. In einem ersten Modus könnten immer gerade diejenigen Lichtemitterdiöden leuchten, die den aktivierten Sensorflächen gegenüberliegen. Wandert der Finger F hin und her, wandert auch der durch die Lichtemitterdioden 20 gebildete Balkenbereich hin und her. Es ist aber auch ein Modus vorgesehen, bei dem nicht nur diejenigen Lichtemitterdioden 20 leuchten, die den aktivierten Sensorflächen 14 gegenüberliegen, sondern auch diejenigen, die sich bis zum Minimalwert am Ende des Leuchtbalkens erstrecken, so daß sich dessen Länge verändert.

Die Einstellung eines analogen Stellwertes erfolgt also durch Berühren des Sensorstreifens mit dem Finger, wobei z. B. das linke Ende dem kleinsten Wert oder Aus entspricht und das andere Ende dem Maximalwert. Die unmittelbare Rückmeldung erfolgt durch Aufleuchten des Leuchtbalkens vom kleinsten Wert bis zur Position, wo der Finger den Sensorstreifen berührt. Wird der Finger vom Sensorstreifen wieder weggenommen, so bleibt der Leuchtbalken stehen und dienst als relative Anzeige des eingestellten Wertes. Beim erneuten Berühren des Sensorstreifens an einer anderen Stelle paßt sich der Leuchtbalken unmittelbar an. Es besteht weiter die Möglichkeit, mit dem Finger auf dem Sensorstreifen langsam hin und her zu fahren, so daß der Leuchtbalken immer dem Finger folgt, und dabei iterativ den idealen Stellwert zu finden. Eine Streichbewegung über den Sensorstreifen bis hin zum tiefsten Wert oder über das Ende des Sensorstreifens hinaus führt zum Setzen des kleinsten Stellwertes oder zum Ausschalten des Gerätes. Umgekehrt führt ein Streichen mit dem Finger über den Sensorstreifen bis zum Maximalwert und eventuell über das Ende des Sensorstreifens hinaus zum Setzen des maximalen Stellwertes.

Statt kapazitiv arbeitender Sensoren können selbstverständlich auch induktiv, optisch, thermisch und piezoelektrisch arbeitende Sensoren verwendet werden, wobei insbesondere letztere neben dielektrischen auch metallische Abdeckungen zulassen.

Unabhängig davon lassen sich in der nichtdargestellten Steuereinheit Kommandos implementieren, die durch vorbestimmte Berührungszeiten des Stellstreifens auslösbar sind und vorbestimmte Modi (Koomunikations-Modi) zum Betreiben der Stelleinheit bereitstellen, wobei den einzelnen Sensoren oder Sensorengrupen neue Bedeutungen zugeordnet werden.

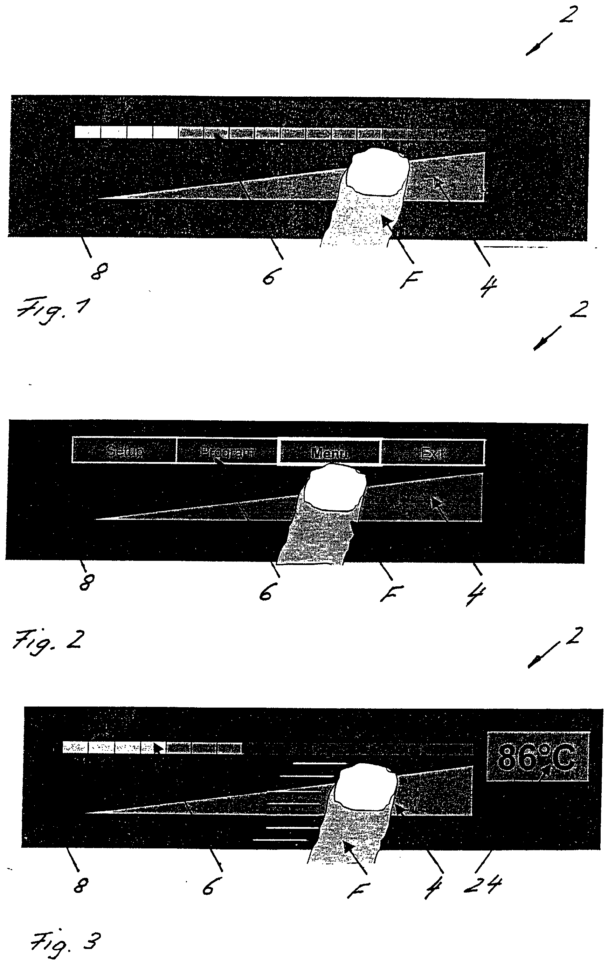

In einem ersten Modus gemäß Fig. 2, der beispielsweise nach einer Berührungszeit von 5 Sekunden zur Verfügung stehen kann, werden soft-keys gebildet, indem auf einem als Grafikdisplay ausgebildeten Anzeigestreifen über Texte oder Symbole Funktionen (Setup, Program, Menu, Exit) angezeigt werden, welche durch Berühren der darunterliegenden zugehörigen Sensoren oder Sensorengruppen des Stellstreifens aktivierbar sind.

In einem zweiten Modus gemäß Fig. 3, der beispielsweise nach 10 Sekunden Berührungszeit zur Verfügung steht, wird eine Zoom-Funktion gebildet, indem eine zusätzliche Digitalanzeige 24 aktiviert und einer Berührungsposition oder einem einmaligen vollständigen Überstreichen des Stellstreifens ein vorbestimmter Bruchteil (z. B. 10%) des ursprünglichen Stellwertes zugeordnet wird. Die Interpretation des Sensorstreifens wird also beipielsweise derart geändert, daß das einmalige Überstreichen des gesamten Sensorstreifens von links nach rechts oder umgekehrt nicht, wie normalerweise, eine Stellwertänderung vom Minimalwert zum Maximalwert oder umgekehrt bewirkt, sondern nur eine Erhöhung oder Reduktion des aktuellen Wertes um einen Bruchteil (z. B. 10 %). Das heißt, eine Veränderung des Stellwertes vom Minimalwert zum Maximalwert erfolgt durch mehrmaliges Überstreichen (z. B. 10 Mal) des gesamten Sensorstreifens in der entsprechenden Richtung.Der Leuchtbalken behält dabei seine ursprüngliche Funktion als Relativ-Anzeige zwischen Minimal- und Maximalwert.

## Patentansprüche

1. Gargerät mit wenigstens einer Stelleinheit (2) mit einem berührungsempfindlichen Stellstreifen (4), dessen Stellabschnitten Stellwerte oder Stellwertbereiche einer vorbestimmten Stellkurve zugeordnet sind, wobei den Stellabschnitten jeweils ein oder mehrere berührungsempfindliche Sensoren zugeordnet sind, **dadurch gekennzeichnet, dass** sich in einer Steuereinheit Kommandos implementieren lassen, die durch vorbestimmte Berührungszeiten des Stellstreifens (4) auslösbar sind und vorbestimmte Modi zum Betreiben der Stelleinheit (2) bereitstellen, wobei den einzelnen Sensoren neue Bedeutungen zugeordnet werden.

2. Gargerät nach Anspruch 1, bei dem der Stellstreifen (4) geradlinig verläuft.

3. Gargerät nach Anspruch 1 oder 2, bei dem die berührungsempfindlichen Sensoren insbesondere kapazitiv, induktiv, optisch, thermisch, piezoelektrisch oder dgl. arbeiten und berührbare Plattenbereiche aufweisen oder mit diesen zusammenwirken.

4. Gargerät nach einem der Ansprüche 1 bis 3, bei dem dem Stellstreifen (4) ein Anzeigestreifen (6) zugeordnet ist, dessen Anzeigeabschnitte korrespondierenden Stellabschnitten des Stellstreifens (4) zugeordnet oder wahlweise zuordenbar sind und insbesondere jeweils eine oder mehrere Lichtemitterdioden (20) oder dgl. und/oder ein oder mehrere Grafikdisplays oder Bereiche von diesen aufweisen.

5. Gargerät nach Anspruch 4, bei dem die Anzeigeabschnitte Plattenbereiche aufweisen, die untereinander und mit den Plattenbereichen der Stellabschnitte verbunden sein können.

6. Gargerät nach Anspruch 4 oder 5, bei dem jeder Anzeigeabschnitt oder jede vorbestimmte Gruppe von Anzeigeabschnitten eine andere Farbe aufweist.

7. Gargerät nach einem der Ansprüche 4 bis 6, bei dem die Aktivierung der Anzeigeabschnitte der Berührung der Stellabschnitte folgt.

8. Gargerät nach Anspruch 7, bei dem die Berührung eines Stellabschnittes zur Aktivierung eines zugeordneten Anzeigeabschnitts oder eines von einem vorbestimmten Ende des Anzeigestreifens ausgehenden Bandes von Anzeigeabschnitten führt.

9. Gargerät nach Anspruch 7 oder 8, bei dem die Aktivierung des oder der Anzeigeabschnitte des Anzeigestreifens (6) bis zur nächsten Berührung des Stellstreifens (4) erhalten bleibt.

10. Gargerät nach einem der Ansprüche 1 bis 9, bei dem die Stellkurve von einem Minimalwert, der insbesondere einem Auszustand des Haushaltsgerätes entspricht, zu einem Maximalwert verläuft.

11. Gargerät nach einem der Ansprüche 1 bis 10, bei dem die Modi auf dem Anzeigestreifen (6) anzeigbar sind.

12. Gargerät nach einem der Ansprüche 1 bis 11, bei dem die Modi ein oder mehrere durch Berührung aktivierbare Soft-keys bereitstellen.

13. Gargerät nach einem der Ansprüche 1 bis 12, bei dem die Modi eine oder mehrere Zoom-Funktionen bereitstellen, der oder denen insbesondere wenigstens ein Anzeigeabschnitt des Anzeigestreifens (6) und/oder eine zusätzliche Zoom-Anzeige (24) zugeordnet ist.

14. Gargerät nach Anspruch 13, bei dem die Zoom-Einstellung durch abschnittsweises und/oder ein oder mehrmaliges Überstreichen des Stellstreifens (4) erfolgt.

15. Gargerät nach einem der Ansprüche 1 bis 14, bei dem die Stellwerte Leistung, Temperatur, Druck, Feuchtigkeit, Umluft oder dgl. sind.

16. Gargerät nach einem der Ansprüche 3 bis 15, bei dem die Plattenbereiche der Stell- und/oder Anzeigeabschnitte ein Bedien- und/oder Anzeigefeld (8) bilden, das Teil einer Umhüllung des Gargerätes ist.

17. Gargerät nach Anspruch 16, bei dem zumindest der das Bedien- und/oder Anzeigefeld bildende Teil der Umhüllung dielektrisch oder metallisch ist und/oder plattenförmig ist.

18. Gargerät nach Anspruch 16 oder 17, bei dem die Umhüllung eine Platte eines Kochfeldes, insbesondere eine Glaskeramikplatte oder eine Edelstahlpatte, ist.

19. Gargerät nach einem der Ansprüche 1 bis 18, bei dem dem Stellstreifen (4) ein oder mehrere, an unterschiedlichen Stellen angeordnete Anzeigestreifen (6) zugeordnet sind.

## Claims

1. Cooking appliance comprising at least one adjusting unit (2) with a touch-sensitive adjusting strip (4), adjusting values or adjusting value ranges of a predetermined adjusting curve being assigned to the adjusting sections of the said adjusting strip, wherein one or more touch-sensitive sensors are assigned to each of the adjusting sections, **characterized in that** commands which can be triggered by predetermined contact times of the adjusting strip (4) and which provide predetermined modes for operating the adjusting unit (2) can be implemented in a control unit, wherein new meanings are assigned to the individual sensors.

2. Cooking appliance according to Claim 1, in which the adjusting strip (4) runs in a straight line.

3. Cooking appliance according to Claim 1 or 2, in which the touch-sensitive sensors operate, in particular, in a capacitive, inductive, optical, thermal, piezoelectric or similar manner and have contactable plate regions or interact with the said plate regions.

4. Cooking appliance according to one of Claims 1 to 3, in which an indicator strip (6) is assigned to the adjusting strip (4), the indicator sections of the said indicator strip being assigned or selectively assignable to corresponding adjusting sections of the adjusting strip (4) and, in particular, each having one or more light-emitting diodes (20) or the like and/or one or more graphic displays or regions thereof.

5. Cooking appliance according to Claim 4, in which the indicator sections have plate regions which can be connected to one another and to the plate regions of the adjusting sections.

6. Cooking appliance according to Claim 4 or 5, in which each indicator section or each predetermined group of indicator sections has a different colour.

7. Cooking appliance according to one of Claims 4 to 6, in which activation of the indicator sections follows contact being made with the adjusting sections.

8. Cooking appliance according to Claim 7, in which contact being made with an adjusting section leads to activation of an associated indicator section or a line of indicator sections which starts from a predetermined end of the indicator strip.

9. Cooking appliance according to Claim 7 or 8, in which the activation of the indicator section or sections of the indicator strip (6) is maintained until contact is next made with the adjusting strip (4).

10. Cooking appliance according to one of Claims 1 to 9, in which the adjusting curve runs from a minimum value, which corresponds, in particular, to an off state of the domestic appliance, to a maximum value.

11. Cooking appliance according to one of Claims 1 to 10, in which the modes are indicated on the indicator strip (6).

12. Cooking appliance according to one of Claims 1 to 11, in which the modes provide one or more softkeys which can be activated by contact.

13. Cooking appliance according to one of Claims 1 to 12, in which the modes provide one or more zoom functions, in particular at least one indicator section of the indicator strip (6) and/or an additional zoom indicator (24) being assigned to the said one or more zoom functions.

14. Cooking appliance according to Claim 13, in which zoom setting is performed by passing over the adjusting strip (4) in sections and/or one or several times.

15. Cooking appliance according to one of Claims 1 to 14, in which the adjusting values are power, temperature, pressure, moisture, ambient air or the like.

16. Cooking appliance according to one of Claims 3 to 15, in which the plate regions of the adjusting and/or indicator sections form an operator control and/or display panel (8) which is part of a casing of the cooking appliance.

17. Cooking appliance according to Claim 16, in which at least that part of the casing which forms the operator control and/or display panel is dielectric or metallic and/or plate-like.

18. Cooking appliance according to Claim 16 or 17, in which the casing is a plate of a hob, in particular a glass-ceramic plate or a stainless steel plate.

19. Cooking appliance according to one of Claims 1 to 18, in which one or more indicator strips (6) which are arranged at different locations are assigned to the adjusting strip (4).

## Revendications

1. Appareil de cuisson, pourvu d'au moins un module de réglage (2) doté d'une bande de rive (4) tactile, aux segments de réglage de laquelle sont associées des valeurs de réglage ou des plages de valeurs de réglage d'une courbe de réglage prédéfinie, aux segments de réglage étant associés respectivement un ou plusieurs capteurs tactiles, **caractérisé en ce que** des instructions qui sont déclenchables par des temps de contact prédéfinis de la bande de rive (4) peuvent être implémentées dans une unité de commande et mettent à disposition des modes prédéfinis pour le fonctionnement du module de réglage (2), aux capteurs individuels étant affectées de nouvelles significations.

2. Appareil de cuisson selon la revendication 1, sur lequel la bande de rive (4) s'écoule en ligne droite.

3. Appareil de cuisson selon la revendication 1 ou 2, sur lequel les capteurs tactiles fonctionnent de manière notamment capacitive, inductive, optique, thermique, piézoélectrique ou similaires et comportent des zones en plaques tactiles ou coopèrent avec celles-ci.

4. Appareil de cuisson selon l'une quelconque des revendications 1 à 3, sur lequel à la bande de rive (4) est associée une bande d'affichage (6) dont les segments d'affichage sont affectés ou affectables au choix à des segments de réglage correspondants de la bande de rive (4) et comportent notamment chacun une ou plusieurs diodes électroluminescentes (20) ou similaires et/ou un ou plusieurs écrans graphiques ou zones de ceux-ci.

5. Appareil de cuisson selon la revendication 4, sur lequel les segments d'affichage comportent des zones en plaques, qui peuvent être assemblées entre elles et avec les zones en plaque des segments de réglage.

6. Appareil de cuisson selon la revendication 4 ou 5, sur lequel chaque segment d'affichage ou chaque groupe prédéfini de segments d'affichage présente une couleur différente.

7. Appareil de cuisson selon l'une quelconque des revendications 4 à 6, sur lequel l'activation des segments d'affichage fait suite au contact avec les segments de réglage.

8. Appareil de cuisson selon la revendication 7, sur lequel le contact avec un segment de réglage conduit à l'activation d'un segment d'affichage associé ou d'une bande de segments d'affichage partant d'une extrémité prédéfinie de la bande d'affichage.

9. Appareil de cuisson selon la revendication 7 ou 8, sur lequel l'activation du ou des segments d'affichage de la bande d'affichage (6) reste maintenue jusqu'au prochain contact avec la bande de rive (4).

10. Appareil de cuisson selon l'une quelconque des revendications 1 à 9, sur lequel la courbe de réglage s'écoule d'une valeur minimale qui correspond notamment à un état d'arrêt de l'appareil électro-ménager vers une valeur maximale.

11. Appareil de cuisson selon l'une quelconque des revendications 1 à 10, sur lequel les modes sont affichables sur la bande d'affichage (6).

12. Appareil de cuisson selon l'une quelconque des revendications 1 à 11, sur lequel les modes mettent à disposition une ou plusieurs touches programmables, activables par contact.

13. Appareil de cuisson selon l'une quelconque des revendications 1 à 12, sur lequel les modes mettent à disposition une ou plusieurs fonctions de zoom à laquelle ou auxquelles est associé notamment au moins un segment d'affichage de la bande d'affichage (6) et/ou un affichage en zoom (24) supplémentaire.

14. Appareil de cuisson selon la revendication 13, sur lequel le réglage du zoom s'effectue par effleurement de parties et/ou par effleurement répété de la bande de rive (4).

15. Appareil de cuisson selon l'une quelconque des revendications 1 à 14, sur lequel les valeurs de réglage sont la puissance, la température, la pression, l'humidité, l'air ventilé ou similaires.

16. Appareil de cuisson selon l'une quelconque des revendications 3 à 15, sur lequel les zones en plaques des segments de réglage et/ou segments d'affichage forment une zone de commande et/ou d'affichage (8) qui est une partie d'une enveloppe de l'appareil de cuisson.

17. Appareil de cuisson selon la revendication 16, sur lequel au moins la partie de l'enveloppe qui forme la zone de commande et/ou d'affichage est diélectrique ou métallique et/ou en forme de plaque.

18. Appareil de cuisson selon la revendication 16 ou 17, sur lequel l'enveloppe est une plaque d'une table de cuisson, notamment d'une plaque vitrocéramique ou d'une plaque en acier inoxydable.

19. Appareil de cuisson selon l'une quelconque des revendications 1 à 18, sur lequel à la bande de rive (4) sont associées une ou plusieurs bandes d'affichage (6) placées en différents endroits.
